# EUROPEAN PATENT APPLICATION

(11) **EP 0 663 457 A1**
(43) Date of publication of application: **19.07.1995**
(21) Application number: 95100221.1
(22) Date of filing: 09.01.1995
(51) Int. Cl.: C23C 14/04, C23C 14/54

(54) **System for depositing material on a substrate**

(30) Priority: 13.01.1994 US 181647
(71) Applicant: Hughes Aircraft Company, Los Angeles, California 90080-0028 (US)
(72) Inventor: Nester, James F., Ridgefield, Connecticut 06877 (US); Zarowin, Charles B., Pacific Palisades, California 90272 (US)
(74) Representative: KUHNEN, WACKER & PARTNER

(57) **Abstract**

A system (**10**) for locally controlling the deposition of material onto a wafer (**14**) includes a plasma puck (**32**) that locally contains a plasma such that a plasma assisted chemical vapor transport process deposits material in a localized controlled region.

## Description

### BACKGROUND OF THE INVENTION

The present invention generally relates to a system for depositing material on a substrate and, in particular, relates to one such system for the precise localized control of plasma assisted chemical vapor deposition of material of a predetermined profile or thicknesses over an area of a substrate or a semiconductor wafer. The theory of plasma assisted chemical transport (PAVT) is fully discussed in C.B. Zarowin, "A Theory of Plasma Assisted Chemical Vapor Transport Processes", J.Appl.Phys, 57(3), 929 (1985). This article identifies and prescribes the physical conditions under which such a deposition can be performed. As one example of such a PAVT deposition reactions, silicon substrates react in a hydrogen or chlorine plasma to permit the deposition of silicon (as a sink) on some other substrate. As another example, the process of depositing a "diamond-like carbon" (DLC) film is known wherein a graphite carbon electrode reacts with a hydrogen plasma to generate a gaseous hydrocarbon that diffuses to a silicon electrode where the reverse reaction deposits carbon with an ion energy induced phase modification to DLC. Such examples are more fully discussed in C.B. Zarowin et al., "New "diamond-like-carbon" film deposition using plasma assisted chemical vapor transport" Appl.Phys.Lett., 48(12), 759 (1986) and U.S. Patent No. 4,647,512 entitled Diamond-like Carbon Films And Process For Production Thereof, issued to Venkataramanan, et al., on March 3, 1987. In these deposition processes, except by approaching a generalized overall thickness uniformity, no attempt is made to control the thickness profile of the deposited material. Both of these references discuss a deposition process that involves a generic chemical vapor transport (CVT) heterogeneous reaction including a solid S and a reactant A. The solid S and reactant A, when used for etching, react to generate a compound B. When used for material deposition, the compound B decomposes to deposit the solid S onto a surface, or sink.

A plasma assisted chemical vapor transport process that accurately and controllably locally removes, or etches, a predetermined amount of material to locally shape, or profile, a surface of a preselected area of the substrate has been described in U.S. Patent No. 4,668,366, entitled OPTICAL FIGURING BY PLASMA ASSISTED CHEMICAL TRANSPORT AND ETCHING APPARATUS THEREFOR and issued on May 26, 1987 to Zarowin, C.B.; "Rapid Optical Figuring of Aspherical Surfaces with Plasma Assisted Chemical Etching (PACE) by L. D. Bollinger et al. SPIE, Vol. 1618, 14 (1991); "Rapid, nonmechanical, damage-free figuring of optical surfaces using plasma-assisted chemical etching (PACE)"; Part I Experimental Results" by L. David Bollinger et al. SPIE, Vol. 966, 82 (1988), and "Rapid, non-mechanical, damage-free figuring of optical surfaces using plasma assisted chemical etching (PACE); Part II Theory and Process Control" by C. B. Zarowin et al. SPIE, Vol. 966, 91 (1988).

Although such techniques as described in these references have proven effective to date, none of these techniques provide for the precise localized control of the deposition of material. As mentioned above, the layers of deposited material formed by conventional techniques are, in fact, only generally uniform and controlled only by the temperature and pressure of the process. Consequently, it is highly desirable to provide a system that overcomes these drawbacks of conventional layers formed by generalized deposition techniques.

### SUMMARY OF THE INVENTION

Accordingly, it is one object of the present invention to provide a system for the localized control of the deposition of material on a substrate that overcomes the above-recited drawbacks of the conventional material deposition systems.

This object is accomplished, at least in part, by a system for depositing material on a wafer including means for locally controlling the deposition of material on a surface of a wafer using plasma assisted chemical deposition in accordance with a predetermined profile.

Other objects and advantages of the present invention will become apparent to those skilled in the art from the following detailed description read in conjunction with the appended claims and the drawings attached hereto.

### BRIEF DESCRIPTION OF THE DRAWING

The drawing, not drawn to scale, includes:
Figure 1 which is a block diagram of a system for depositing material on a substrate embodying the principles of the present invention; and
Figure 2 which is a cross-sectional view of an apparatus particularly adapted for use in a system embodying the principles of the present invention.

### DETAILED DESCRIPTION OF THE INVENTION

As more fully set forth hereinafter a system for depositing material is described that generates a predetermined additive or deposited profile using a plasma assisted deposition process. In the interest of ensuring a complete and thorough understanding of the present invention, the following generalized discussion is provided. In general, in order to achieve plasma assisted chemical deposition rather than etching, in a two surface plasma reactor, there are, typically, two techniques that can be employed, the first technique being to provide the reactant gas A into a plasma reactor and etch one of the surfaces as a source of the material to be deposited, i. e., the compound B, and another surface on which deposition occurs as a sink. The other technique involves the introduction of the compound B into the reactor so that deposition occurs because the concentration of B exceeds its equilibrium value at the surface temperature and/or its energetic particle bombardment.

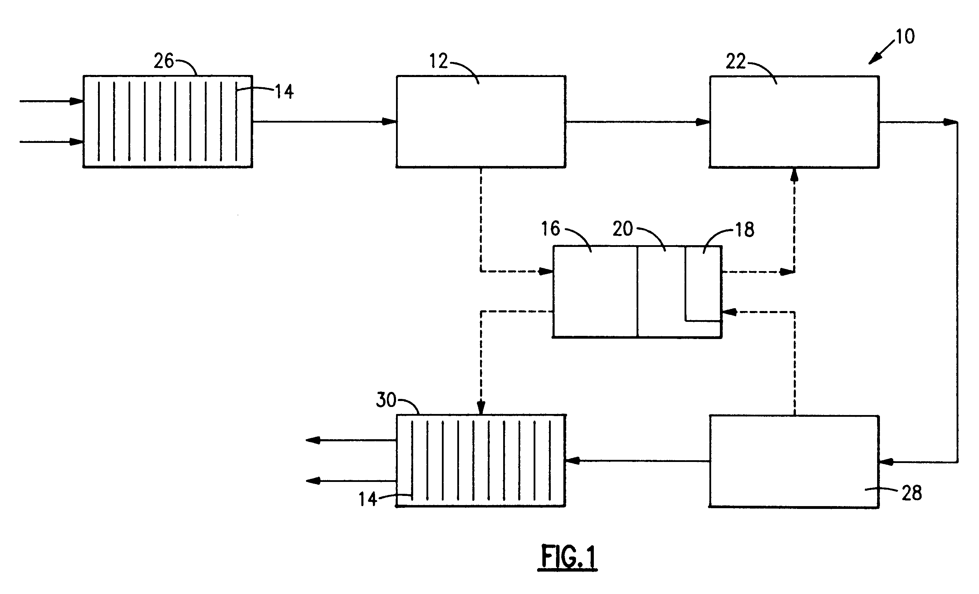

A system for the controlled localized depositing of material, generally indicated at **10** in Figure 1 and embodying the principles of the present invention, includes means **12** for determining thickness profile data for a surface of a substrate **14**, means **16** for converting the thickness profile data to a dwell time versus position map stored in a map memory **18** in a system controller **20** and means **22** for locally controlling the deposition of material onto a surface **24** of the substrate **14** in accordance with the dwell time versus position map such that the substrate **14** has a preselected thickness of material deposited thereupon. As used herein the phrase "substrate" and the idiomatic variations thereof, can include any material. However, for clarity the substrate **14** described herein will be a semiconductor wafer.

In one particular embodiment, the system **10** can also includes a means **26** for delivering one or more wafers **14** to the thickness profile data determining means **12,** means **28** for determining thickness profile data of a wafer **14** subsequent to depositing material thereupon, and means **30** for transporting one or more wafers **14** from the means **22** for depositing material.

The present system **10** for the localized control of the deposition of material on a substrate **14** is hereinafter discussed and described with respect to the application of the system **10** for forming a layer of material on a semiconductor wafer. Typically, the system **10,** because not only the temperature and pressure of the reactor is controlled but the plasma chemistry is also controlled, is able to deposit localized layers having thicknesses ranging form a single atomic layer up to thicknesses in the millimeters.

A typical wafer **14** is initially conveyed to the means **12** for determining the thickness profile data of the silicon surface **24**. In one embodiment, the means **12** can be a multi-point measurement apparatus that measures the surface **24** at a substantial number of points. For example, the means **12** can be a commercially available capacitive thickness measuring instrument. The number of points selected for actual measurement for any given process is determined primarily by the desired spatial resolution of the surface. That is, the finer the desired surface detail to be resolved, the greater the number of points would be measured. The spatial resolution in the system **10** is effectively limited primarily by the size of the localized plasma electrode.

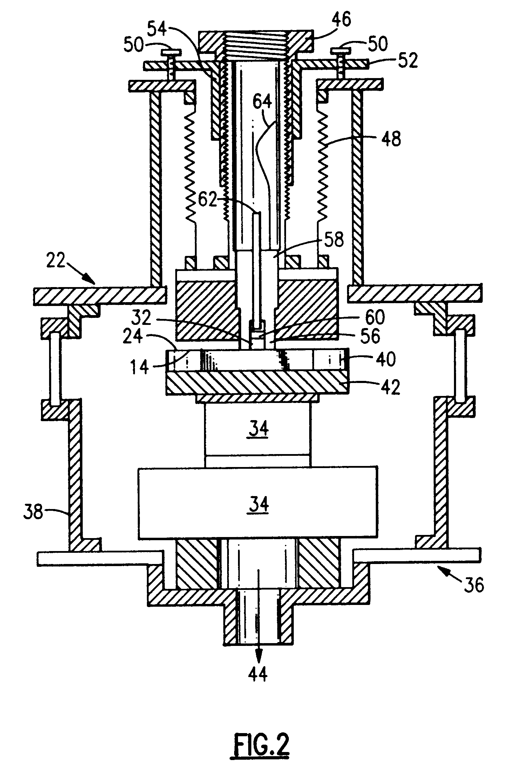

The initial profile data representing the point-by-point thickness of the surface **24** of the wafer **14** is then processed by the converting means **16** to yield a dwell time versus position map for the entire surface **24** of the wafer **14.** As more fully discussed with respect to Figure 2, the preferred means **22** for depositing material is a plasma puck **32** having a deposition footprint smaller than a dimension corresponding to an allowable film thickness variation along the wafer surface **24** upon which material is to be deposited. The input data to the converting means **16** includes at least three factors, the measured initial thickness profile data, the desired final layer thickness profile data and the spatial material deposition rate pattern of the plasma control puck **32.** In the event that the spatial material deposition rate pattern is unknown for a particular material, empirical measurements should be taken of that material prior to the formation of the dwell time versus position map. The measured initial thickness profile data and the desired target layer thickness profile provide a thickness error map of material thickness to be deposited onto the wafer surface **24.** Effectively, in one instance, the thickness error map is generated by a point-by point addition of the desired end thickness to the measured initial thickness. In the specific application where a final uniform layer thickness is desired on a previously uncoated substrate, the material thickness error map would be the initial thickness, i. e., zero, plus a constant. It will be recognized that any arbitrary thickness profile can be produced by specifying a material thickness error map constructed from the initial measured thickness profile data and the target film profile data. In general, the converting means **16** can be the equivalent of the arithmetic logic unit of a personal computer including appropriate input, output, memory and other peripheral units. Similarly, the system controller **20** can be any of the typical computer controllers readily available for machine control operations.

The dwell time versus position map is then computed from the thickness error map and stored in the map memory **18**. The dwell time map represents the length of time that the plasma deposition puck **32** must spend at each specified position over the wafer surface **24** to produce the specified target thickness profile. The dwell time map computation incorporates the spatial material deposition rate of the plasma puck **32.** In one embodiment, the dwell time map is calculated using a known two-dimensional fast Fourier transform implementation of the Fourier Deconvolution Theorem on the thickness error map.

Finally, the dwell time map is used by the system controller **20** to generate a set of instructions to the translation mechanism of the apparatus. The instructions are used to control the velocity of the plasma puck **32** over the wafer surface **24** in a predetermined path so as to execute the dwell time versus position map of the plasma puck **32** and thus provide the target thickness profile. In the embodiment shown in Figure 2, the machine instructions control the motion of an x-y stage **34,** discussed hereinafter so that the wafer **14** is moved under the plasma puck **32.**

In the preferred embodiment, the means **22** for locally controlling the deposition of material includes a plasma assisted chemical etching chamber **36** as shown in Figure 2. In the embodiment shown in Figure 2, the material deposition means **22** includes a vacuum chamber **38** having a plasma source disposed therein. The chamber **38** further includes a wafer support **40** disposed on a table **42.** Preferably, the temperature of the wafer support **40** can be controlled to avoid possible high temperature effects and to maintain the plasma puck **32** and the wafer **14** within about 100 degrees Celsius of each other. The plasma puck **32** and the table are **42** arranged such that relative motion can be controlled therebetween. In the chamber **36** shown, the table **40** is moved with respect to the plasma puck **32** by translation means **34** in two orthogonal directions, i. e., the x and y planes of the wafer. Such translation means **34** are known in the art and further detailed description is not believed necessary. Further, the chamber **36** includes a port **44** via which a preselected vacuum can be established within the chamber **36.**

In the embodiment shown, the wafer **14** upon which a layer is to be deposited is positioned on the wafer support **40.** Preferably, the plasma puck **32** is essentially fixed although a height adjustment means and a tilt adjustment means are provided. In one embodiment, the height adjustment means includes providing the plasma puck **32** with an externally threaded extension **46** that can be rotated to control the distance between the plasma puck **32** and the wafer **14.** The height adjustment means **46** is enclosed with a bellows **48** to ensure the integrity of the vacuum chamber **48.**

In this embodiment, the tilt adjustment means **50** includes a plurality of control screws threaded through a flange **52** of a bracket **54** affixed to the extension of the plasma source **56.** The flange **52** is disposed external the vacuum chamber **36** such that the screws apply pressure against the vacuum chamber **36** to tilt the plasma source **56** with respect to the table **40.**

Preferably, as shown in Figure 2, the plasma source **56** includes a plasma containment member **58** having a recess **60** formed therein proximate to the table **40.** The recess **60** of the plasma containment member **58** effectively defines the perimeter of the plasma puck **32**. The member **58** further includes a plasma gas inlet opening **62** such that the feedgas, or reactant, for the plasma can be provided to the plasma chamber **36.** Further, the member **58** includes an RF energy supply means **64** to establish the plasma gas discharge within the plasma containment member **58.**

The means **26** for delivering wafers **14** to the thickness profile data determining means **12** and the means **30** for transporting wafers **14** from the means **22** for the localized controlled deposition of material can include one or more wafer holders. In one embodiment, the wafer holders are conventional semiconductor wafer cassettes and are delivered and removed using conventional automated cassette handling systems.

In the preferred embodiment, the means **28** for determining thickness profile data of a wafer **14** subsequent to the deposition of material thereupon is the same type as that used for the means **12.** It will be understood that, if desirable, the same measuring instrument can be used for the measurement of the wafer **14** both before and after material deposition.

The system **10** described herein is advantageous in that the use of a plasma to effect the localized control of material deposition introduces a level of localized control over the deposition of material that was heretofore unknown in the semiconductor field.

In one mode of operation, the plasma puck **32** can be used as a source of the material compound B, for example silicon, such that when it reacts with the reactant A, provided through the plasma gas inlet opening **62** the solid B, i. e., silicon is deposited upon the localized surface **24** of the wafer **14.**

Although the present invention has been discussed herein with respect to a particular embodiment, it will be understood that other configurations and arrangements may also be implemented by those skilled in the art which do not depart from the spirit and scope hereof. Hence, the present invention is deemed limited only by the appended claims and the reasonable interpretation thereof,

## Claims

1. A system for the localized controlled deposition of material onto a surface of a substrate; comprising:
means for determining thickness profile data for said surface of said substrate;
means for generating a dwell time versus position map for said substrate; said map being generated from said thickness profile data; and
means for locally depositing material onto said surface of said substrate, said material deposition means including a plasma puck, said plasma puck being comparatively physically smaller than said surface and controlled in accordance with said dwell time versus position map.

2. The system as claimed in Claim 1 wherein said thickness profile determining means includes measuring the thickness of said surface on a point-by-point basis.

3. The system as claimed in Claim 1, further comprising;
means for delivering one or more wafers to said thickness profile data determining means.

4. The system as claimed in Claim 1, further comprising:
means for determining thickness profile data subsequent to said material removal.

5. The system as claimed in Claim 1, further comprising:
means for transporting one or more wafers away from said material removal means.

6. The system as claimed in Claim 1 wherein said generating means includes means for subtracting said thickness profile data from preselected profile data such that said dwell time versus position map represents a surface having said preselected profile.

7. The system as claimed in Claim 1 wherein said means for locally depositing material includes:
a plasma chemical etching chamber having means for receiving said wafer;
a plasma puck for locally containing a plasma; and
means for controlling the dwell time and position of said plasma puck in accordance with said dwell time versus position map.

8. The system as claimed in Claim 7 wherein said plasma chamber further includes:
means for tilting said wafer with respect to said plasma puck; and
means for controlling the distance between said wafer and said plasma puck.

9. The system as claimed in claim 7 wherein said controlling means includes means for moving said wafer with respect to said plasma puck.
